# EUROPEAN PATENT APPLICATION

(11) **EP 4 550 427 A1**
(43) Date of publication of application: **07.05.2025**
(21) Application number: 22949448.9
(22) Date of filing: 30.06.2022
(51) Int. Cl.: H01L 31/10, G02B 6/12

(54) **PHOTODETECTOR**

(71) Applicant: NIPPON TELEGRAPH AND TELEPHONE CORPORATION, Chiyoda-ku, Tokyo 100-8116 (JP)
(72) Inventor: HINAKURA Yosuke, Musashino-shi, Tokyo 180-8585 (JP); HONDA Kentaro, Musashino-shi, Tokyo 180-8585 (JP); KIKUCHI Kiyofumi, Musashino-shi, Tokyo 180-8585 (JP); IKUMA Yuichiro, Musashino-shi, Tokyo 180-8585 (JP)
(74) Representative: TBK
(86) International application number: PCT/JP2022/026391
(87) International publication number: WO 2024/004175

(57) **Abstract**

A photodetector of the present invention includes: a photodiode; and a protection diode. The photodiode and the protection diode are integrated on a same semiconductor substrate. The photodiode includes a semiconductor portion made of at least one type of semiconductor material, an anode electrode, and a cathode electrode. The protection diode includes a core layer, a semiconductor portion provided in the core layer and including a first-type semiconductor region doped with first-type impurity ions and a second-type semiconductor region doped with second-type impurity ions, an anode electrode, and a cathode electrode. The semiconductor portion of the protection diode includes only one type of semiconductor material used for the semiconductor portion of the photodiode. The anode electrodes of the protection diode and the photodiode are connected to each other. The cathode electrodes of the protection diode and the photodiode are connected to each other.

## Description

### Technical Field

The present invention relates to a photodetector used in an optical communication system or an optical information processing system, and particularly relates to a structure for providing a photodetector having resistance to electrostatic discharge.

### Background Art

With the recent spread of optical communication, cost reduction of an optical communication apparatus is required. As one of the solutions is a method of forming an optical circuit constituting the optical communication apparatus on a large-diameter wafer such as a silicon wafer using a minute optical circuit technology such as silicon photonics. As a result, a material cost per chip can be reduced, and the cost of the optical communication apparatus can be reduced.

A representative photodetector formed on a silicon (Si) substrate using such a technology includes a germanium photodetector (hereinafter, also referred to as GePD) allowing monolithic integration (Patent Literature 1). However, this photodetector does not include a protection circuit, and therefore has a problem of being susceptible to electrostatic discharge.

Meanwhile, Patent Literature 2 discloses a photodetector including a protection circuit (protection zener diode). The protection zener diode of the photodetector is formed using both a Ge layer and a Si layer.

### Citation List

### Patent Literature

Patent Literature 1: JP 5370857 B
Patent Literature 2: JP 6981365 B

### Summary of Invention

### Technical Problem

However, the photodetector including the protection zener diode of Patent literature 2 performs ion implantation (doping step) using a mask in order to form each of the Ge layer and the Si layer. At that time, due to a manufacturing error, the zener diode for the protection circuit may cause a positional deviation between a light-absorbing layer (Ge layer) and a p-type semiconductor portion, an n-type semiconductor portion (pn junction), or a p-type semiconductor portion, an intrinsic semiconductor portion, and an n-type semiconductor portion (pin junction) on a Si core layer. There is a problem that this positional deviation affects the rectification characteristics of the photodetector.

The present invention has been made in view of such a problem, and an object of the present invention is to provide a photodetector capable of eliminating an influence on rectification characteristics due to a positional deviation in a protection zener diode.

### Solution to Problem

In order to achieve the above object, a first aspect of the present invention is a photodetector including: a photodiode; and a protection diode. The photodiode and the protection diode are integrated on a same semiconductor substrate. The photodiode includes a semiconductor portion made of at least one type of semiconductor material, an anode electrode, and a cathode electrode. The protection diode includes a core layer, a semiconductor portion provided in the core layer and including a first-type semiconductor region doped with first-type impurity ions and a second-type semiconductor region doped with second-type impurity ions, an anode electrode, and a cathode electrode. The semiconductor portion of the protection diode includes only one type of semiconductor material used for the semiconductor portion of the photodiode. The anode electrode of the protection diode and the anode electrode of the photodiode are connected to each other. The cathode electrode of the protection diode and the cathode electrode of the photodiode are connected to each other.

### Advantageous Effects of Invention

The photodetector of the present invention can eliminate the influence on the rectification characteristics due to the positional deviation in the protection zener diode.

### Brief Description of Drawings

Fig. 1 is a view illustrating a top view according to a first embodiment of the present invention.
Fig. 2 is a view illustrating the cross-sectional structure of a zener diode included in a photodetector according to the first embodiment of the present invention.
Fig. 3 is a view illustrating the upper surface of a photodetector according to a second embodiment of the present invention.
Fig. 4 is a view illustrating a top view of a photodetector of Comparative Example.
Fig. 5 is a view illustrating the cross-sectional structure of a zener diode included in the photodetector of Comparative Example.

### Description of Embodiments

Hereinafter, a form of a photodetector of the present invention will be described in detail with reference to embodiments and drawings. In the drawings, portions having the same functions are denoted by the same numbers to clarify the description. However, the present invention is not limited to contents described in the embodiments described below, and it is obvious to those skilled in the art that the forms and the details can be variously changed without departing from the spirit of the invention disclosed in the present specification and the like.

### (First Embodiment)

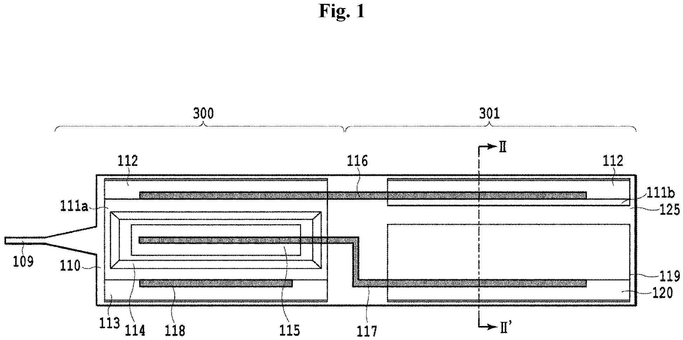

Fig. 1 is a top view illustrating the configuration of a photodetector according to an embodiment of the present invention.

The photodetector according to the embodiment of the present invention is configured by electrically connecting a GePD 300 and a protection zener diode 301 in parallel.

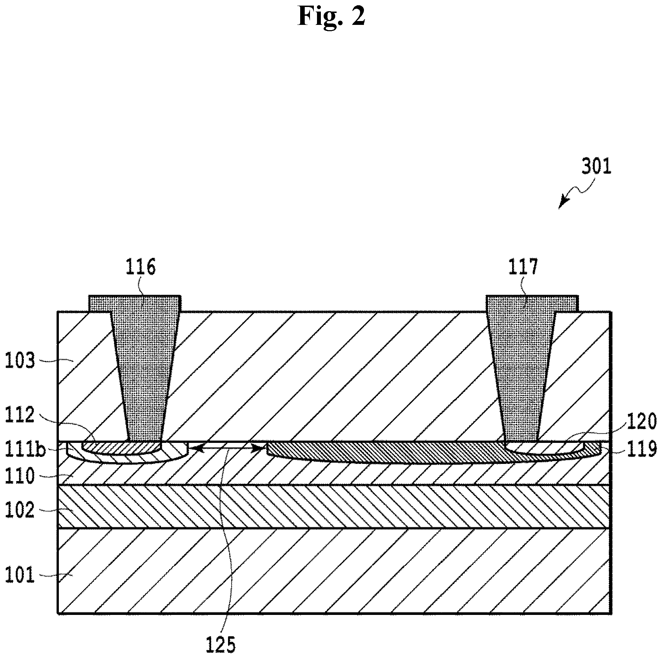

The GePD 300 includes a core layer 110 doped with a first-type impurity (n-type impurity), a (optical) waveguide 109 connected to the core layer 110, a light-absorbing layer (Ge layer) 114 doped with a second-type impurity on the core layer 110, a lower cladding layer 102 (see Fig. 2) below the core layer 110, a semiconductor substrate 101 (see Fig. 2) below the lower cladding layer 102, and an upper cladding layer 103 (see Fig. 2) above the core layer 110 and the light-absorbing layer. In the core layer 110, a p-type silicon slab 111a and p++ silicon contact regions 112 and 113 are formed. An n-type Ge region 115 is formed in the light-absorbing layer 114. The p++ silicon contact regions 112 and 113 and the n-type Ge region 115 are provided with electrodes 116, 117, and 118 respectively connected thereto. When light enters the core layer 110 and is absorbed by the light-absorbing layer 114, a current flows between the electrode 117 and the electrodes 116 and 118, and the GePD 300 can detect the current to detect the light.

In the present embodiment, the GePD 300 and the zener diode 301 are linearly arranged when viewed from the waveguide 109, and are arranged in the incident direction of light from the waveguide 109.

In the zener diode 301, a p-type silicon slab (region) 111b doped with p-type impurity ions, a p++ silicon contact region 112 doped with a p-type impurity at a high concentration and playing a role of forming ohmic contact with the electrode 116, an n-type silicon slab 119 doped with n-type impurity ions, and an n++ silicon contact region 120 doped with an n-type impurity at a high concentration and playing a role of forming ohmic contact with the electrode 117 are formed in the core layer 110 continuous with the GePD 300. The n-type silicon slab 119 is also referred to as an n-type Si slab or an n-type silicon region. The n++ silicon contact region is also referred to as an n-part silicon contact region or an n-type electrode part. On the p++ silicon contact region 112 and the n++ silicon contact region 120, an upper cladding layer 103 (see Fig. 2) similarly continuous with the GePD 300 is formed, and the electrode 116 and the electrode 117 are formed so as to be in contact with the p++ silicon contact region 112 and the n++ silicon contact region 120, respectively, via a plurality of openings formed in the upper cladding layer 103. The electrodes 116 and 117 are continuous with the electrodes 116 and 117 of the GePD 300.

Fig. 2 is a cross-sectional view of the zener diode 301 taken along line II-II'. In the core layer 110, the p++ silicon contact region 112 is located on the p-type silicon region 111b and the n++ silicon contact region 120 is located on the n-type silicon slab 119. The p++ silicon contact region 112 is connected to the electrode 116, and the n++ silicon contact region 120 is connected to the electrode 117. An intrinsic silicon region 125 without ion implantation is present between the p-type silicon region 111b and the n-type silicon slab 119. In Fig. 2, the operation threshold value of the zener diode is determined by the size of the intrinsic silicon region 125 indicated by an arrow and the doping concentrations of the p-type silicon region 111b and the n-type silicon slab 119. In order to adjust the operation threshold value, the intrinsic silicon region 125 may be eliminated, and the p-type silicon region 111b and the n-type silicon slab 119 may be brought into contact with each other to form a PN junction.

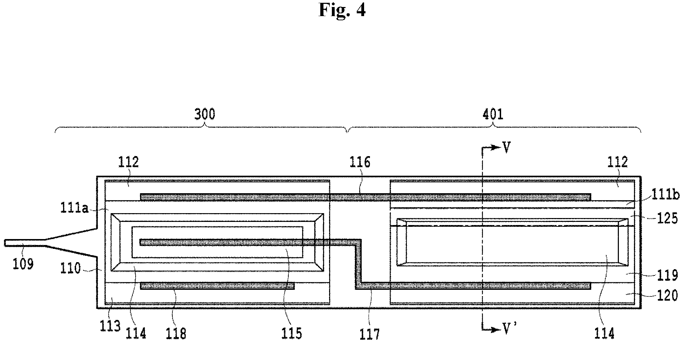

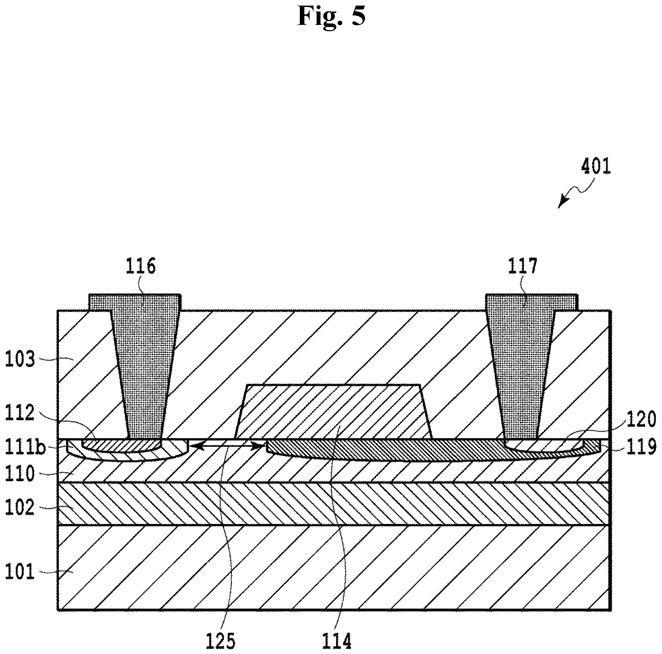

The upper cladding layer 103 is directly formed on the p-type semiconductor portion (the p-type silicon region 111b and the p++ silicon contact region 112), the I-type semiconductor portion (the intrinsic silicon region 125), and the p-type semiconductor portion (the n-type silicon slab 119 and the n++ silicon contact region 120). As will be described later in comparison with Comparative Example illustrated in Figs. 4 and 5, a Ge layer in contact with the core layer 110 is not formed. That is, in the photodetector according to the present embodiment, the upper cladding layer 103 is directly formed on the p-type semiconductor portion and the n-type semiconductor portion, and only the upper cladding layer is provided between the electrodes connected to the p-type semiconductor portion and the n-type semiconductor portion. A semiconductor portion of a protection diode includes only one type of semiconductor material used for a semiconductor portion of the photodiode. As a result, there is no room for occurrence of a positional displacement between a pn junction including the p-type semiconductor portion and the n-type semiconductor portion and the light-absorbing layer (Ge layer), and as a result, it is possible to eliminate the influence on the rectification characteristics of the photodiode.

The applicant estimates that the reason why the photodetector of the present embodiment can be driven is as follows: an impurity doping concentration is set such that the voltage of the zener breakdown of the protection diode is smaller than the avalanche breakdown of the photodetector main body.

The anode electrode of the zener diode 301 is connected to the anode electrode of the GePD 300, and the cathode electrode of the zener diode 301 is connected to the cathode electrode of the GePD 300.

When the electrode 116 functions as the anode electrode, the electrodes 117 and 118 function as the cathode electrode. When the electrode 116 functions as the cathode electrode, the electrodes 117 and 118 function as the anode electrode. Only the upper cladding layer 103 is present between the electrodes 117 and 118.

The core layer 110 of the GePD 300 and the semiconductor portion (n-type silicon slab 119 and n++ silicon contact region 120) of the protection diode 301 are made of the same material.

As described above, the core layer 110 of the GePD 300 is the same layer as the semiconductor portion (n-type silicon slab 119 and n++ silicon contact region 120) of the protection diode 301.

In the present embodiment, Ge is used as the main material of the light-absorbing layer 114, but other semiconductor materials such as GeSn, InGaAs, and InGaAsP may be used.

In Fig. 2, the GePD 300 and the protection diode 301 are on the continuous core layer 110, but not necessary, and may be fabricated on separate Si slabs. The height and material of the layer used as the Si slab are substantially the same as those of the core layer 110, but may be separated from each other.

In the present embodiment, Si is used as the main material of the core layer 110, but other semiconductor materials such as InP and SiC may be used. The position of the p-type semiconductor portion and the position of the n-type semiconductor portion may be reversed. As described above, the protection diode 301 may employ a pin junction or a pn junction. Furthermore, as described above, a single protection diode 301 may be used, or a plurality of protection diodes 301 may be loaded in parallel.

### (Second Embodiment)

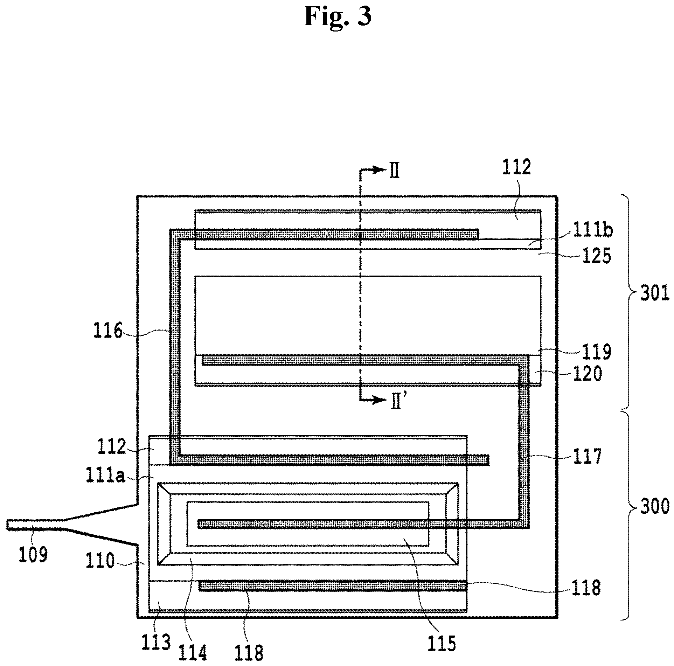

As illustrated in Fig. 3, a photodetector according to an embodiment of the present invention is configured by electrically connecting a GePD 300 and a zener diode 301 as a protection circuit in series.

The GePD 300 has a configuration in which the GePD 300 and the zener diode 301 are linearly arranged when viewed from the waveguide 109 in the first embodiment of Fig. 1, but has a configuration in which the GePD 300 and the Zener diode 301 are not linearly arranged when viewed from the waveguide 109 and are arranged in a direction orthogonal to the incident direction of light from the waveguide 109 in a second embodiment of Fig. 3. The longitudinal direction of the Ge layer 114 of the GePD 300 and the longitudinal direction of the p++ silicon contact region 112 and the n++ silicon contact region 120 of the zener diode 301 are in a substantially parallel relationship. A sectional view taken along dashed line II-II' in Fig. 3 corresponds to Fig. 2.

In the configuration of Fig. 3, the light traveling straight from the waveguide 109 does not enter the zener diode 301, and therefore the zener diode does not detect a photocurrent.

Also in the present embodiment, a semiconductor portion of the protection diode 301 is made of only one of semiconductor materials used for a semiconductor portion of the photodiode 300. Therefore, it is possible to provide a photodetector including a protection circuit in which the rectification characteristics of the photodetector of the present embodiment is not affected by a positional deviation between a light-absorbing layer (Ge layer) and a pn junction including a p-type semiconductor portion and an n-type semiconductor portion, or a p-type semiconductor portion, an I-type semiconductor portion, an n-type semiconductor portion (pin junction).

Although one zener diode (protection diode) 301 is connected to the GePD 300 in Fig. 3, a plurality of zener diodes 301 may be connected. In that case, although the high-speed operation characteristics of the GePD are affected, high resistance to electrostatic discharge can be obtained.

### (Comparative Example)

Figs. 4 and 5 illustrate the configuration of a photodetector of Comparative Example. A GePD 300 has the same configuration as that of the GePD 300 of the first and second embodiments. In Comparative Example, the GePD 300 and a zener diode 401 are linearly arranged when viewed from a waveguide 109, and are arranged in the incident direction of light from the waveguide 109. A sectional view taken along line V-V' in Fig. 4 corresponds to Fig. 5.

The zener diode 401 of the present Comparative Example is different from the zener diode 301 of the first and second embodiments in that a Ge layer 114 is present in a zener diode for a protection circuit. A positional deviation may occur between the Ge layer and a p-type semiconductor portion, an n-type semiconductor portion (pn junction), or a p-type semiconductor portion, an intrinsic semiconductor portion, and an n-type semiconductor portion (pin junction) on a Si core layer, and there is a problem that the positional deviation affects the rectification characteristics of the photodetector.

Fig. 5 is a cross-sectional view taken along line V-V' of the zener diode 401 of the present invention. The Ge layer 114 is formed on an n-type silicon slab 119 and not on a p-type silicon (Si) region 111b. The Ge layer 114 is provided between the electrodes 117 and 118.

The p-type silicon region 111b in the core layer 110 is not immediately below the Ge layer 114, and the n-type silicon slab 119 is under the Ge layer 114. The p-type silicon region 111b may be immediately below the Ge layer 114.

Since the Ge layer 114 is formed by implanting a Ge material using a mask during a manufacturing step, the positional deviation from the PN junction corresponding to the p-semiconductor portion and the n-type semiconductor portion, or the p-type semiconductor portion, the i-type semiconductor portion, and the n-type semiconductor portion (pin junction) may occur, and there is a problem that the positional deviation affects the rectification characteristics of the photodetector. Meanwhile, in the detector according to the embodiment of the present invention described above with reference to Figs. 1 to 3, no Ge layer is present under the upper cladding layer 103, and therefore there is no room for occurrence of the positional deviation, which makes it possible to eliminate the influence on the rectification characteristics of the photodetector. The detector according to the embodiment of the present invention has an advantage that a problem that has occurred when the Ge layer 114 is present can be solved. Specifically, the interface between Ge and Si serves as a leakage current path, which causes variations in a reverse current when the alignment accuracy between the PN junction and the Ge layer 114 is not good. However, the detector according to the embodiment of the present invention can suppress such variations.

### Industrial Applicability

The present invention relates to a photodetector used in an optical communication system or an optical information processing system, and can be particularly applied to a photodetector having resistance to electrostatic discharge.

### Reference Signs List

- 101: semiconductor substrate
- 102: lower cladding layer
- 103: upper cladding layer
- 109: waveguide
- 110: core layer
- 111a: p-type silicon slab
- 111b: p-type silicon slab (region)
- 112: silicon contact region
- 113: p++ silicon contact region
- 114: light-absorbing layer (Ge layer)
- 115: n-type Ge region
- 116: electrode
- 117: electrode
- 118: electrode
- 119: n-type silicon slab
- 120: silicon contact region
- 125: intrinsic silicon region
- 300: GePD
- 301: protection (zener) diode
- 401: protection (zener) diode

## Claims

1. A photodetector comprising:
a photodiode; and
a protection diode,
wherein:
the photodiode and the protection diode are integrated on a same semiconductor substrate;
the photodiode includes a semiconductor portion made of at least one type of semiconductor material, an anode electrode, and a cathode electrode;
the protection diode includes a core layer, a semiconductor portion provided in the core layer and including a first-type semiconductor region doped with first-type impurity ions and a second-type semiconductor region doped with second-type impurity ions, an anode electrode, and a cathode electrode;
the semiconductor portion of the protection diode includes only one type of semiconductor material used for the semiconductor portion of the photodiode;
the anode electrode of the protection diode and the anode electrode of the photodiode are connected to each other; and
the cathode electrode of the protection diode and the cathode electrode of the photodiode are connected to each other.

2. The photodetector according to claim 1, wherein
the semiconductor portion of the photodiode includes:
a core layer doped with a first-type impurity;
an optical waveguide connected to the core layer;
a light-absorbing layer doped with a second-type impurity on the core layer;
a lower cladding layer below the core layer;
an upper cladding layer on the core layer and the light-absorbing layer; and
an electrode connected to each of the core layer and the light-absorbing layer.

3. The photodetector according to claim 2, wherein the core layer of the photodiode and the semiconductor portion of the protection diode are made of the same material.

4. The photodetector according to claim 2 or 3, wherein the core layer of the photodiode and the semiconductor portion of the protection diode share the same layer.

5. The photodetector according to claim 2, wherein a main material of the core layer of the photodiode is silicon, and a main material of the light-absorbing layer is germanium.

6. The photodetector according to claim 1 or 2, wherein the photodiode and the protection diode are arranged in an incident direction of light passing through a silicon waveguide layer included in the photodiode.

7. The photodetector according to claim 1 or 2, wherein the photodiode and the protection diode are arranged in a direction perpendicular to an incident direction of light passing through a silicon waveguide layer included in the photodiode.

8. The photodetector according to claim 1 or 2, wherein a plurality of the protection diodes are connected to the photodiode.

9. The photodetector according to claim 1 or 2, wherein only the upper cladding layer is formed on the semiconductor portion of the protection diode and between the electrodes of the protection diode.
